# EUROPEAN PATENT APPLICATION

(11) **EP 4 379 827 A1**
(43) Date of publication of application: **05.06.2024**
(21) Application number: 22849948.9
(22) Date of filing: 01.08.2022
(51) Int. Cl.: H01L 33/58, H01L 33/20, H01L 33/36, H01L 33/44, H01L 33/62, H01L 27/15, H01L 27/12

(54) **LIGHT-EMITTING MODULE AND DISPLAY DEVICE USING SAME**

(30) Priority: 30.07.2021 US 202163227659 P; 27.07.2022 US 202263392850 P; 29.07.2022 US 202217877505
(71) Applicant: Seoul Viosys Co., Ltd., Ansan-si, Gyeonggi-do 15429 (KR)
(72) Inventor: CHA, Nam Goo, Ansan-si Gyeonggi-do 15429 (KR); PARK, Seong Chan, Ansan-si Gyeonggi-do 15429 (KR)
(74) Representative: Isarpatent
(86) International application number: PCT/KR2022/011275
(87) International publication number: WO 2023/008975

(57) **Abstract**

The present disclosure relates to a light emitting module and a display apparatus using the same. Specifically, one embodiment of the present disclosure provides a light emitting module including: a light emitting structure configured to emit light; and a light transmitting layer configured to transmit light emitted from the light emitting structure, wherein the light transmitting layer has a light scattering region in which one or more voids for refracting the light are formed.

## Description

### TECHNICAL FIELD

The present disclosure relates to a light emitting module and a display apparatus using the same.

### BACKGROUND

A display apparatus is a device that provides an image, and its importance is gradually increasing with the development of multimedia. In response to this, various display apparatuses such as a liquid crystal display device and a light emitting display device have been developed. Such a display apparatus may include a plurality of light emitting devices.

A light emitting device is a type of semiconductor used to transmit and receive signals by converting electricity into infrared rays or light using the characteristics of a compound semiconductor. In the light emitting device, when a forward voltage is applied to a semiconductor of a specific element, electrons and holes move through the junction of the anode and cathode to be recombined with each other. In this case, the energy level is lowered by the combination of electrons and holes, and light can be emitted.

However, as the size of the light emitting device is reduced, the recent light emitting device may have a bonding force sufficient to ensure workability for a subsequent process. In addition, any one of a plurality of light emitting devices may have a beam angle smaller than beam angles of the other light emitting devices depending on a position, a substrate state, a manufacturing method, and the like. Due to the light emitting device having such a narrow beam angle, an image of the display apparatus may not be uniformly formed depending on a viewing angle.

### DETAILED DESCRIPTION OF THE DISCLOSURE

### TECHNICAL PROBLEM

One embodiment of the present disclosure provides a display apparatus capable of increasing a beam angle of one or more of a plurality of light emitting structures by forming a void in a light transmitting layer.

In addition, the present disclosure provides a display apparatus including a light emitting device capable of increasing bonding force by forming an uneven portion on a bump layer.

### TECHNICAL SOLUTION TO THE PROBLEM

In accordance with an aspect of the present disclosure, there may be provided a light emitting module including: a light emitting structure configured to emit light; and a light transmitting layer configured to transmit light emitted from the light emitting structure, wherein the light transmitting layer has a light scattering region in which one or more voids for refracting the light are formed.

Further, the light emitting module may be provided in which the light scattering region is formed in a region of the light transmitting layer which overlaps the light emitting structure.

Further, there may be provided the light emitting module in which the light scattering region is formed in a non-overlapping region of the light transmitting layer which does not overlap the light emitting structure.

Further, there may be provided the light emitting module in which the light scattering region includes a plurality of light scattering regions, and a distance between the plurality of light scattering regions is less than or equal to a distance between any one of the plurality of light scattering regions and the overlapping region.

Further, there may be provided the light emitting module in which the one or more voids include a plurality of voids, and the plurality of voids are spaced apart from each other in the light scattering region.

Further, there may be provided the light emitting module in which the light transmitting layer has a light incident surface facing the light emitting structure, and the one or more voids are disposed between a point of 30% of a thickness of the light transmitting layer from the light incident surface and a point of 60% of the thickness of the light transmitting layer from the light incident surface.

Further, there may be provided the light emitting module in which each of the one or more voids has a predetermined major axis length in a longitudinal direction with a longest length between opposite ends and a predetermined minor axis length in a transverse direction with a shortest length between opposite ends, and the major axis length is 7 µm or more and 35 µm or less.

Further, there may be provided the light emitting module in which the minor axis length is 2 µm or more and 6 µm or less.

Further, there may be provided the light emitting module in which the light emitting structure includes a plurality of light emitting structures, and the plurality of light emitting structures are supported on the light transmitting layer so as to be spaced apart from each other, and the one or more voids refract light emitted from each of the plurality of light emitting structures.

Further, there may be provided the light emitting module in which the plurality of light emitting structures have different beam angles.

Further, there may be provided the light emitting module in which the light scattering region is formed in a region where two or more beam angles of the plurality of light emitting structures overlap in an inner region of the light transmitting layer.

Further, there may be provided the light emitting module in which the light scattering region is formed in a region where the beam angles of the plurality of light emitting structures do not overlap in an inner region of the light transmitting layer.

Further, there may be provided the light emitting module in which the one or more voids include a plurality of voids, and the plurality of voids are arranged to be spaced apart from each other in a thickness direction of the light transmitting layer, or arranged to be spaced apart from each other along a direction in which the plurality of light emitting structures are arranged.

Further, there may be provided the light emitting module in which the light emitting structure includes: a first conductivity type semiconductor layer; and a mesa laminated on a partial region of the first conductivity type semiconductor layer and including an active layer and a second conductivity type semiconductor layer, and each of the one or more voids has a major axis length in a longitudinal direction with a longest length between opposite ends and a minor axis length in a transverse direction with a shortest length between opposite ends, and the major axis length is smaller than a thickness of the first conductivity type semiconductor layer.

Further, there may be provided the light emitting module in which the minor axis length is smaller than a thickness of the active layer.

Further, there may be provided the light emitting module in which the light emitting structure includes: an electrode layer electrically connected to the first conductivity type semiconductor layer and the mesa; an insulating layer covering the first conductivity type semiconductor layer and the mesa; and a bump layer covering the insulating layer and having an uneven portion formed on one surface facing the insulating layer.

Further, there may be provided the light emitting module in which the uneven portion includes a plurality of convex portions and a plurality of concave portions, and a length from an end of the convex portions of the uneven portion of the bump layer to an opposite surface to the one surface of the bump layer is 1 µm or more and 3 µm or less.

Further, there may be provided the light emitting module in which a shape corresponding to the uneven portion is formed on a surface of the insulating layer which is in contact with the uneven portion of the bump layer.

Further, there may be provided a light emitting module including: a light emitting structure configured to emit light; and a light transmitting layer configured to transmit light emitted from the light emitting structure, wherein the light emitting structure includes: a first conductivity type semiconductor layer; a mesa laminated on a partial region of the first conductivity type semiconductor layer and including an active layer and a second conductivity type semiconductor layer; an adhesive layer for bonding the first conductivity type semiconductor layer to the light transmitting layer; and a black blocking layer disposed between the light transmitting layer and the adhesive layer and configured to partially block light emitted from the light emitting structure.

Further, there may be provided a display apparatus including: a plurality of light emitting modules; and a panel substrate supporting the plurality of light emitting modules, wherein the light emitting module includes: a light emitting structure configured to emit light; and a light transmitting layer configured to transmit light emitted from the light emitting structure, and wherein the light transmitting layer has a light scattering region in which one or more voids for refracting the light are formed.

### ADVANTAGEOUS EFFECTS OF THE DISCLOSURE

In one embodiment of the present disclosure, since the light of any one of the plurality of light emitting structures is refracted by the void, the deviation between the beam angles of the plurality of light emitting structures can be reduced, the image of the display apparatus can be uniformly formed even when viewed from various angles.

Further, by increasing the scattering of light inside the light emitting device, the beam angle of light emitted from the light emitting structure can be improved.

Furthermore, the bonding force between the bump electrode and the insulating layer can be increased by the uneven portion.

### BRIEF DESCRIPTION OF THE DRAWINGS

FIG. 1 is a plan view of a display apparatus according to a first embodiment of the present disclosure.
FIG. 2 is a plan view of a light emitting module of FIG. 1.
FIG. 3 is a partial cross-sectional view of the light emitting module of FIG. 2.
FIG. 4 is a cross-sectional view illustrating a state in which a light scattering region is formed in a light emitting device of FIG. 2.
FIG. 5 is a cross-sectional view illustrating a state in which a light scattering region is formed in a light emitting device according to a second embodiment of the present disclosure.
FIG. 6 is a cross-sectional view illustrating a state in which a light scattering region is formed in a light emitting device according to a third embodiment of the present disclosure.
FIG. 7 is a plan view of a display apparatus according to a fourth embodiment of the present disclosure.
FIG. 8 is a cross-sectional view illustrating a state in which a light scattering region is formed in a light emitting device of FIG. 7.
FIG. 9 is a cross-sectional view illustrating a state in which a light scattering region is formed in a light emitting device according to a fifth embodiment of the present disclosure.
FIG. 10 is a cross-sectional view illustrating a state in which a light scattering region is formed in a light emitting device according to a sixth embodiment of the present disclosure.
FIG. 11 is a cross-sectional view illustrating a state in which a light scattering region is formed in a light emitting device according to a seventh embodiment of the present disclosure.
FIG. 12 is a cross-sectional view of a light emitting device according to an eighth embodiment of the present disclosure.
FIG. 13 is an enlarged view of section A in FIG. 12.
FIG. 14 is an enlarged view according to a modified example of section A in FIG. 12.
FIG. 15 is an enlarged view according to another modified example of section A in FIG. 12.
FIG. 16 is a cross-sectional view of a light emitting device according to a ninth embodiment of the present disclosure.
FIG. 17 is an enlarged view of section B in FIG. 16.
FIG. 18 is an enlarged view according to a modified example of section B in FIG. 16.
FIG. 19 is an enlarged view according to another modified example of section B in FIG. 16.
FIG. 20 is a cross-sectional view of a light emitting device according to a tenth embodiment of the present disclosure.
FIG. 21 is an enlarged view of section C in FIG. 20.
FIG. 22 is an enlarged view of section D in FIG. 20.

### MODE FOR CARRYING OUT THE DISCLOSURE

Hereinafter, specific embodiments for implementing the technical idea of the present disclosure will be described in detail with reference to the drawings.

In addition, in the description of the present disclosure, if it is determined that a detailed description of a related known configuration or function may obscure the gist of the present disclosure, the detailed description thereof will be omitted.

In addition, it should be understood that when it is described that a component 'contacts', 'is connected to', or 'is supported by' another component, it may directly contact, be directly connected to, or be directly supported by another component, but other component may exist therebetween.

The terms used herein are only used to describe specific embodiments and are not intended to limit the present disclosure. The singular expression includes the plural expression unless the context clearly expresses otherwise.

Further, in the present specification, the expressions of upper, lower, side, and the like are described based on the illustration in the drawings, and may be expressed differently if the orientation of the corresponding object is changed. For the same reason, some components are exaggerated, omitted, or schematically illustrated in the accompanying drawings, and the size of each component does not fully reflect the actual size.

Furthermore, the terms including an ordinal number such as first, second, etc. may be used to describe various components, but the components are not limited by these terms. These terms are used only for the purpose of distinguishing one component from another.

The meaning of "including" as used herein, specifies a particular characteristic, region, integer, step, operation, element and/or component, and does not exclude the presence or addition of other particular characteristic, region, integer, step, operation, elements, component and/or group.

Hereinafter, a display apparatus 1 according to the present disclosure will be described with reference to the drawings.

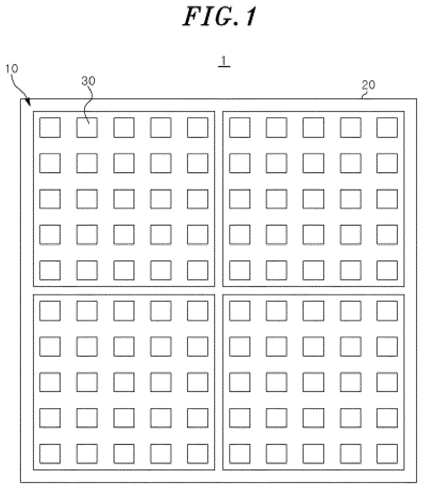

Referring to FIG. 1, a display apparatus 1 according to a first embodiment of the present disclosure is included in a TV, a smart watch, a headset, augmented reality glasses, and the like to provide an image to a user. The display apparatus 1 may include a light emitting module 10 and a panel substrate 20.

The light emitting module 10 may emit light to a wide region. The light emitting module 10 may be provided in plural, and a plurality of light emitting modules 10 may be supported on the panel substrate 20. For example, the plurality of light emitting modules 10 may be arranged to form an n x n matrix on the panel substrate 20. However, this is merely an example, and the plurality of light emitting modules 10 may be arranged irregularly.

The panel substrate 20 may support the light emitting module 10. The panel substrate 20 may be electrically connected to the light emitting module 10. For example, the panel substrate 20 may be a printed circuit board (PCB), a thin film transistor (TFT), and a transparent substrate capable of transmitting light. The panel substrate 20 may be provided with one or more of wirings, transistors, resistors, and capacitors therein. In addition, a pad for electrically connecting to the light emitting module 10 may be provided on an upper surface of the panel substrate 20.

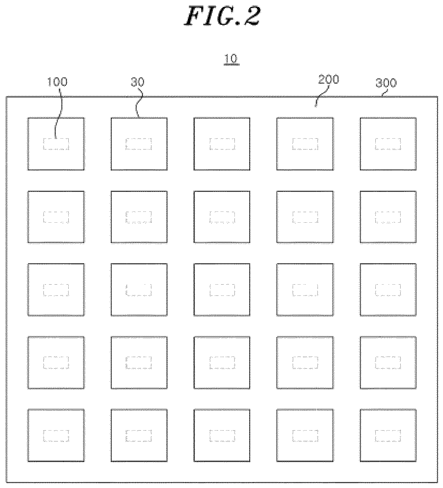

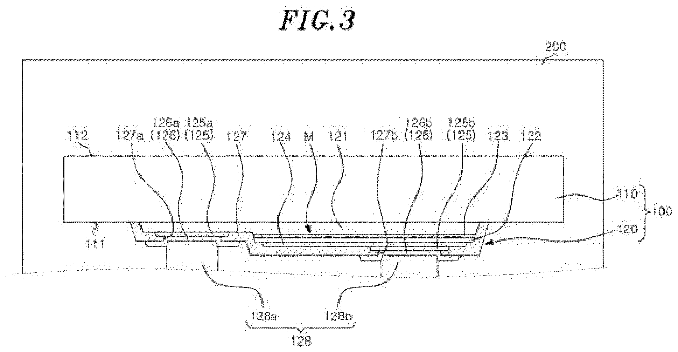

Meanwhile, referring to FIGS. 2 and 3, the light emitting module 10 may include a light emitting unit 30, a molding part 200, and a module substrate 300.

The light emitting unit 30 may generate light. The light emitting unit 30 may include one or more light emitting devices 100. For example, the light emitting unit 30 may include a light emitting device 100 that emits at least one of red light, green light, and blue light. In this case, the light emitting device 100 may be provided in a long rectangular shape having a major axis and a minor axis, and may have a relatively small horizontal cross-sectional area. For example, when the light emitting device has a rectangular shape, a length in a longitudinal direction of the light emitting device may be less than twice a length in a transverse direction. However, the light emitting device is not limited thereto, and may have various shapes.

The molding part 200 may protect the light emitting unit 30 and improve light extraction efficiency of the light emitting unit 30. For example, the molding part 200 may encapsulate the light emitting unit 30 and may refract light emitted from the light emitting unit 30. In addition, the molding part 200 is extended to have a preset thickness. For example, the molding part 200 may extend so that a height from an upper surface of the module substrate 300 to an upper end of the molding part 200 is longer than a height from the upper surface of the module substrate 300 to an upper end of the light emitting unit 30. The molding part 200 may be formed of a material including at least one of a silicon-based, an epoxy-based, a polymethyl methacrylate (PMMA)-based, a polyethylene (PE)-based, and a polystyrene (PS)-based material. Further, the molding part 200 may include black molding to increase the contrast between the light emitting unit 30 or one or more light emitting devices 100 constituting the light emitting unit 30.

The module substrate 300 may support the light emitting unit 30 and the molding part 200. The module substrate 300 may be electrically connected to the light emitting module 10. For example, the module substrate 300 may be a printed circuit board (PCB), a thin film transistor (TFT), and a transparent substrate capable of transmitting light. The module substrate 300 may be provided with one or more of wirings, transistors, resistors, and capacitors therein. Further, a pad for electrically connecting to the light emitting unit 30 may be provided on the upper surface of the module substrate 300. Furthermore, a plurality of light emitting units 30 may be disposed on the upper surface of the module substrate 300. For example, the plurality of light emitting units 30 may be arranged to form an n x n matrix on the module substrate 300. However, this is merely an example, and the plurality of light emitting units 30 may be arranged irregularly.

Meanwhile, referring to FIG. 3, the light emitting unit 30 may include one or more light emitting devices 100. The light emitting device 100 may include a light transmitting layer 110 and a light emitting structure 120.

The light transmitting layer 110 may be an insulating or conductive substrate. The light transmitting layer 110 may be a growth substrate for growing the light emitting structure 120, and may include, for example, one or more of gallium nitride, GaAs, Si, sapphire, patterned sapphire, PET, a glass substrate, and quartz. The light transmitting layer 110 may be disposed on a light emitting surface of the display apparatus 1, and light generated from the light emitting structure 120 may be emitted to the outside through the light transmitting layer 110. The light transmitting layer 110 may have a light incident surface 111 and a light emitting surface 112.

The light incident surface 111 is one surface, of both surfaces of the light transmitting layer 110, which faces the light emitting structure 120, and may be a surface through which light is entering from the light emitting structure 120 to the light transmitting layer 110. The light incident surface 111 may be a flat surface, but is not limited thereto. For example, the light transmitting layer 110 may have an uneven pattern in at least a partial region of the light incident surface 111 facing the light emitting structure 120. The uneven pattern formed on the light transmitting layer 110 may include a plurality of protrusions, and the plurality of protrusions may be formed in a regular or irregular pattern. In addition, some of the plurality of protrusions on a lower surface of the light transmitting layer 110 may be positioned between the light emitting structure 120 and the light transmitting layer 110. The plurality of protrusions can improve the extraction efficiency of light emitted from the light emitting structure 120.

In addition, the light emitting surface 112 may be a surface through which light is emitted from the light transmitting layer 110 as a surface opposite to the light incident surface 111 of both surfaces of the light transmitting layer 110. The light transmitting layer 110 may include an anti-reflection region (not shown) on the light emitting surface 112. Further, a glare prevention layer (not shown) may be included on the light emitting surface 112 of the light transmitting layer 110. For example, the light transmitting layer 110 may have a thickness of 30 µm to 300 µm, but is not limited thereto. Furthermore, the light transmitting layer 110 of the present disclosure may have a role of a transparent substrate, and when applied to a transparent display, the light transmitting layer 110 may include a circuit for electrical connection with the light emitting structure 120.

The light transmitting layer 110 has a plurality of side surfaces extending from an upper surface to the lower surface of the light transmitting layer 110, and the side surfaces of the light transmitting layer 110 have arbitrary angles. At least two of the plurality of side surfaces of the light transmitting layer 110 may extend at different angles from the lower surface or the upper surface of the light transmitting layer 110. In addition, at least one side surface of the light transmitting layer 110 may include a region having upper and lower inclination angles different from each other, and the light transmitting layer 110 may include a roughened surface on the side surface. By forming an inclined surface or a roughened surface on one surface of the light transmitting layer 110, the emitting efficiency of light emitted from the light emitting structure 120 may be improved.

The light emitting structure 120 may generate light. The light emitting structure 120 includes a first conductivity type semiconductor layer 121, a second conductivity type semiconductor layer 122, an active layer 123, an ohmic layer 124, a contact layer 125, an electrode layer 126, an insulating layer 127, and bump layer 128.

The first conductivity type semiconductor layer 121 may have an inclined side surface. An inclination angle of the inclined side surface of the first conductivity type semiconductor layer 121 may be as gentle as about 60 degrees or less with respect to the lower surface of the light transmitting layer 110. In addition, the second conductivity type semiconductor layer 122 may be disposed on the first conductivity type semiconductor layer 121. Meanwhile, the first conductivity type semiconductor layer 121 may include n-type impurities (e.g., Si, Ge, Sn, Te), and the second conductivity type semiconductor layer 122 may include p-type impurities (e.g., Mg, Sr, Ba). For example, the first conductivity type semiconductor layer 121 may include GaN, AlGaN, GaAs, GaP, InGaP, GaAlP, InAlP, or InGaAlP containing Si as a dopant, and the second conductivity type semiconductor layer 122 may include GaN, AlGaN, GaAs, GaP, InGaP, GaAlP, InAlP, or InGaAlP containing Mg as a dopant. In this case, in the present embodiment, the first conductivity type semiconductor layer 121 may be an n-type semiconductor layer, and the second conductivity type semiconductor layer 122 may be a p-type semiconductor layer. However, this is merely an example, and the first conductivity type semiconductor layer 121 may include p-type impurities, and the second conductivity type semiconductor layer 122 may include n-type impurities. Moreover, although the first conductivity type semiconductor layer 121 is illustrated as a single layer in the drawing, this is merely an example and may be formed of multiple layers and may include a superlattice layer.

The active layer 123 may include a well layer and a barrier layer in a multiple quantum well (MQW) structure, and composition ratio or bandgap energy of the well layer may be adjusted to emit a desired wavelength. For example, the active layer 123 may emit red light, green light, blue light, or ultraviolet light depending on a semiconductor material constituting the layer and a composition ratio thereof. The active layer 123 may be positioned between the first conductivity type semiconductor layer 121 and the second conductivity type semiconductor layer 122.

The first conductivity type semiconductor layer 121, the second conductivity type semiconductor layer 122, and the active layer 123 may include a III-V group semiconductor, and may include, as an example, a nitride-based semiconductor such as Al, Ga, In.

Meanwhile, the light emitting structure 120 may include a mesa M including the second conductivity type semiconductor layer 122 and the active layer 123. In other words, the second conductivity type semiconductor layer 122 and the active layer 123 included in the light emitting structure 120 may form the mesa M. In addition, the mesa M may further include at least a portion of the first conductivity type semiconductor layer 121. The mesa M may be positioned on a partial region of the first conductivity type semiconductor layer 121, and the mesa M may have a thickness within a range of approximately 1 to 2 µm. In the present embodiment, a portion of the first conductivity type semiconductor layer 121 may be exposed outside the mesa M. In addition, in some regions, an inclined surface of the mesa M is parallel to the inclined surface of the first conductivity type semiconductor layer 121, and accordingly, the exposed surface of the lower surface of the first conductivity type semiconductor layer 121 may be limited to one side of the mesa M. However, the present embodiment is not limited thereto, and the lower surface of the first conductivity type semiconductor layer 121 may be exposed along a periphery of the mesa M. Moreover, in another embodiment, a through hole (not shown) or a groove (not shown) may be formed in the mesa M to expose the first conductivity type semiconductor layer 121.

Meanwhile, when viewed from an up-down direction, the first conductivity type semiconductor layer 121 and the mesa M may be divided into a region overlapping each other and a region where the first conductivity type semiconductor layer 121 and the mesa M do not overlap. In this case, light may be emitted through the region where the first conductivity type semiconductor layer 121 and the mesa M do not overlap. For example, the region where the first conductivity type semiconductor layer 121 and the mesa M overlap may be larger than the region where the first conductivity type semiconductor layer 121 and the mesa M do not overlap.

The ohmic layer 124 may be in ohmic contact with the first conductivity type semiconductor layer 121 or the second conductivity type semiconductor layer 122. The ohmic layer 124 may be disposed on the second conductivity type semiconductor layer 122. In addition, the ohmic layer 124 may be formed as a single layer or a multi-layer, and may be formed as a transparent electrode. For example, the transparent electrode of the ohmic layer 124 may include a light-transmitting conductive oxide layer such as ITO (Indium Tin Oxide), ZnO (Zinc Oxide), ZITO (Zinc Indium Tin Oxide), ZIO (Zinc Indium Oxide), ZTO (Zinc Tin Oxide), GITO (Gallium Indium Tin Oxide), GIO (Gallium Indium Oxide), GZO (Gallium Zinc Oxide), AZO (Aluminum doped Zinc Oxide), FTO (Fluorine Tin Oxide), and the like.

The contact layer 125 may be electrically connected to the ohmic layer 124 and the electrode layer 126. The contact layer 125 may include a first contact pad 125a and a second contact pad 125b.

The first contact pad 125a may be electrically connected to the first conductivity type semiconductor layer 121 and a first electrode pad 126a to be described later. The first contact pad 125a may be in ohmic contact with a region that does not overlap with the mesa M in the first conductivity type semiconductor layer 121. In addition, the first contact pad 125a may include an ohmic metal layer in ohmic contact with the first conductivity type semiconductor layer 121. The first contact pad 125a may be disposed so as not to overlap the second conductivity type semiconductor layer 122 and the active layer 123. In this case, the insulating layer 127 for insulating the first contact pad 125a from the second conductivity type semiconductor layer 122 may be omitted. Meanwhile, the first contact pad 125a may be spaced apart from the mesa M by a sufficient distance in a horizontal direction, and the separation distance may be greater than the thickness of the insulating layer 127. However, when the separation distance of the first contact pad 125a is excessively large, the light emitting region decreases, and thus the separation distance may be smaller than a diameter of the first contact pad 125a.

The second contact pad 125b may be electrically connected to the ohmic layer 124 and a second electrode pad 126b to be described later. The second contact pad 125b may be electrically connected to the ohmic layer 124. In addition, the second contact pad 125b may be spaced apart from the first contact pad 125a. Moreover, the second contact pad 125b may be formed on the mesa M to which the ohmic layer 124 is connected through a lift-off process, for example.

The insulating layer 127 may cover at least a portion of the first conductivity type semiconductor layer 121, the active layer 123, the second conductivity type semiconductor layer 122, the first contact pad 125a and the second contact pad 125b. The insulating layer 127 covers a lower region and side surfaces of the mesa M, and covers the first conductivity type semiconductor layer 121 and side surfaces of the first conductivity type semiconductor layer 121 exposed around the mesa M. In addition, the insulating layer 127 covers at least a portion of the lower surface of the light transmitting layer 110 exposed around the first conductivity type semiconductor layer 121, and covers a region between the contact layer 125 and the mesa M.

In the embodiment of the present disclosure, the insulating layer 127 may be formed to cover almost the entire surface except for a partial region of the second contact pad 125b and a partial region of the first contact pad 125a. The insulating layer 127 may have a plurality of openings 127a and 127b each having a size smaller than an area of the contact layer 125, and may be positioned on only the contact layer 125. That is, the insulating layer 127 may have a first opening 127a and a second opening 127b exposing the first contact pad 125a and the second contact pad 125b. The first opening 127a and the second opening 127b of the insulating layer 127 may have different widths. The first opening 127a and the second opening 127b of the insulating layer 127 may have different areas. In addition, the first opening 127a and the second opening 127b of the insulating layer 127 may have different shapes. The width of the first opening 127a of the insulating layer 127 may be greater than the distance between the first contact pad 125a and the adjacent mesa M in a horizontal direction. Further, the insulating layer 127 may be formed to have a thickness different from that of the first contact pad 125a or the second contact pad 125b. For example, the insulating layer 127 may be formed to be thicker than the first contact pad 125a or the second contact pad 125b, and may have a thickness greater 1.2 times or more than that of the first contact pad 125a or the second contact pad 125b.

The insulating layer 127 includes a distributed Bragg reflector. The distributed Bragg reflector may be formed by repeatedly laminating a plurality of dielectric layers having different refractive indices, and the plurality of dielectric layers may include one or more of TiO₂, SiO₂, HfO₂, ZrO₂, Nb₂O₅, and MgF₂. For example, the insulating layer 127 may have a structure of alternately laminated TiO₂ layers/SiO₂ layers. The distributed Bragg reflector is manufactured to reflect light generated by the active layer 123 and is formed in a plurality of pairs to improve reflectance. In the present embodiment, the distributed Bragg reflector may include 10 to 25 pairs. In this case, the distributed Bragg reflector may be formed to exhibit high reflectance over a relatively wide wavelength range including the peak wavelength of light emitted from the active layer 123. In addition, if necessary, the distributed Bragg reflector may be designed in consideration of the incident angle of light. In this way, the insulating layer 127 may reflect the light generated by the active layer 123 and emit it through the light transmitting layer 110. Further, the insulating layer 127 may include an additional insulating layer 127 together with the distributed Bragg reflector, and, for example, an interface layer positioned under the distributed Bragg reflector and a protective layer covering the distributed Bragg reflector may be included to improve adhesion between the distributed Bragg reflector and its underlying layer. The interface layer may be formed of, for example, a SiOi layer, and the protective layer may be formed of SiO₂ or SiNₓ.

Moreover, the light emitting structure 120 that emits blue light may have higher internal quantum efficiency than the light emitting structures 120 that emit red light and green light. In this case, the light emitting structure 120 emitting blue light may exhibit higher light extraction efficiency than the light emitting structures 120 emitting red light and green light. Accordingly, in order to properly maintain the color mixing ratio of red light, green light, and blue light, the light emitting structure 120 emitting blue light may have a distributed Bragg reflector having a relatively low reflectance compared to the light emitting structures 120 emitting red light and green light.

The electrode layer 126 is disposed on the insulating layer 127 and may be electrically connected to the contact layer 125 and the bump layer 128. The electrode layer 126 may include a first electrode pad 126a and a second electrode pad 126b. In addition, the first electrode pad 126a may be electrically connected to the first contact pad 125a through the first opening 127a of the insulating layer 127, and, if necessary, the first electrode pad 126a may be directly connected to the first conductive semiconductor layer 121. In this case, the first contact pad 125a may be omitted.

The second electrode pad 126b may be electrically connected to the second contact pad 125b. The second electrode pad 126b may be disposed in an upper region of the ohmic layer 124. In addition, the second electrode pad 126b may have the insulating layer 127 interposed between itself and an upper portion of the second contact pad 125b. The second electrode pad 126b is laminated on the insulating layer 127 and may be connected to the second contact pad 125b through the second opening 127b formed in the insulating layer 127. However, this is merely an example, and the second electrode pad 126b may be directly electrically connected to the ohmic layer 124, and the second contact pad 125b may be omitted.

The bump layer 128 may be disposed on the electrode layer 126. The bump layer 128 may include a first bump electrode 128a and a second bump electrode 128b. The first bump electrode 128a may contact the first electrode pad 126a, and the second bump electrode 140b may contact the second electrode pad 126b. The bump layer 128 may include a conductive material. The light emitting device 100 may be electrically connected to the module substrate 300 through the bump layer 128.

Although the light emitting device 100 according to one embodiment of the present disclosure has been described above, the light emitting device 100 may further include a layer having an additional function in addition to the above-described layers. For example, various layers such as a reflective layer (not shown) for reflecting light, an additional insulating layer (not shown) for insulating specific components, and a solder diffusion prevention layer (not shown) for preventing diffusion of solder, and the like.

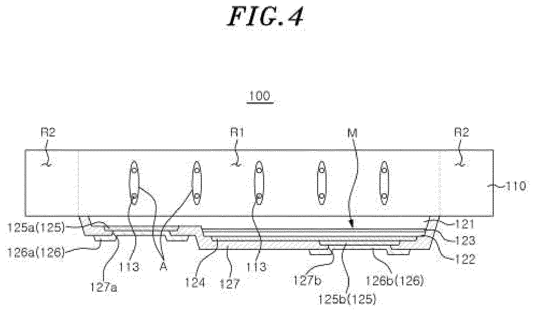

Meanwhile, referring to FIG. 4, the light transmitting layer 110 may have a light scattering region A. The light scattering region A may refract light emitted from the light emitting structure 120. For example, the light scattering region A may adjust a directivity pattern of light emitted from the light emitting structure 120. In addition, the light scattering region A may be formed in the light transmitting layer 110 to be placed in a region overlapping the light emitting structure 120. The light scattering regions A of the light transmitting layer 110 may be continuously formed to form a light scattering line. Further, the light scattering region A of the light transmitting layer 110 may be formed discontinuously, and two adjacent regions may be formed to have different light scattering degrees. In this case, the light scattering region A of the light transmitting layer 110 may include a light scattering pattern or light scattering patterns, a light scattering line pattern or light scattering line patterns, a light scattering form or light scattering forms, a light scattering arrangement or light scattering arrangements, and a light scattering configuration or light scattering configurations.

One or more voids 113 may be formed in the light transmitting layer 110, and the one or more voids 113 may be provided in the light scattering region A. The void 113 may be formed in an inner region of the light transmitting layer 110 through a laser. For example, the void 113 may be formed between a point of 30% a thickness of the light transmitting layer 110 from the light incident surface 111 and a point of 60% of the thickness of the light transmitting layer from the light incident surface 111. The void 113 may be provided in various shapes such as circular, oval, and streamlined shapes, but the present disclosure is not limited thereto. For example, the void 113 may have a major axis length in a longitudinal direction with the longest length between opposite ends, and a minor axis length in a transverse direction with the shortest length between opposite ends. The major axis length of the void 113 may be smaller than a thickness of the first conductivity type semiconductor layer 121, and the minor axis length may be smaller than a thickness of the active layer 123. In addition, the major axis length of the void 113 may be, for example, 7 µm or more and 35 µm or less, and the minor axis length may be, for example, 2 µm or more and 6 µm or less. The void 113 may have a wider shape toward a bottom thereof. Moreover, the void 113 may have an area or density of a reformed region increased toward the lower bottom thereof.

A plurality of voids 113 may be provided in the light scattering region A. In case that the plurality of voids 113 are provided in the light scattering region A, the plurality of voids 113 may be continuously formed or spaced apart from each other to form the light scattering region A. In addition, the plurality of voids 113 may be arranged along a longitudinal direction of the light transmitting layer 110. However, the present disclosure is not limited thereto, and the plurality of voids 113 may be disposed along a width direction of the light transmitting layer 110. Further, the light scattering region A may be formed to extend from the light incident surface 111 to the light emitting surface 112 of the light transmitting layer 110. However, the present disclosure is not limited thereto, and the light scattering region A may have a length smaller than the width or thickness of the light transmitting layer 110 and may be disposed in a partial region of the light transmitting layer 110. Furthermore, the light scattering region A may include a curved region, and may be formed by mixing a curved region and a straight line region.

Meanwhile, the light scattering region A may include a plurality of light scattering regions A provided in the light transmitting layer 110. The plurality of light scattering regions A may be formed in an overlapping region R1 of the light transmitting layer 110. Here, the overlapping region R1 of the light transmitting layer 110 means a region of the light transmitting layer 110 which overlaps the light emitting structure 120 in an up-down direction. The plurality of light scattering regions A is disposed in the overlapping region R1 of the light transmitting layer 110 in a light irradiation region of the light emitting structure 120. In this case, the light directivity pattern of the light emitting structure 120 can be improved to be more uniform. However, this is merely an example, and the light scattering region A may be provided in other forms.

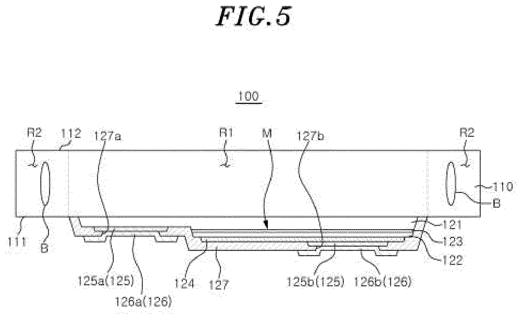

Meanwhile, in addition to the above configuration, according to a second embodiment of the present disclosure, the light transmitting layer 110 may have a light scattering region B. The light scattering region B of FIG. 5 is the same as the light scattering region A of FIG. 4 except for the arrangement in the light transmitting layer 110.

Referring to FIG. 5, the light scattering region B may be formed in a non-overlapping region R2 of the light transmitting layer 110. Here, the non-overlapping region R2 of the light transmitting layer 110 means a region of the light transmitting layer 110 which does not overlap the light emitting structure 120 in the up-down direction. In other words, the non-overlapping region R2 of the light transmitting layer 110 refers to a region adjacent to the overlapping region R1 but distinct from the overlapping region R1. The light scattering region B is disposed in the non-overlapping region R2 of the light transmitting layer 110 in the light irradiation region of the light emitting structure 120. In this case, while the light emitted from the light emitting structure 120 passes through the light transmitting layer 110, a light scattering rate outside the overlapping region of the light emitting structure 120 can be increased. In addition, the uniformity of light emitted to the outside of the light transmitting layer 110 can be improved, and the light uniformity at various angles can be improved.

According to FIGS. 4 and 5, the light scattering regions A and B have been described as being formed in the overlapping region R1 or the non-overlapping region R2 of the light transmitting layer 110, but this is merely an example, and the light scattering regions A and B may be formed in both the overlapping region R1 and the non-overlapping region R2 in the light irradiation region. In addition, the light scattering regions A and B may be formed at the boundary between the overlapping region R1 and the non-overlapping region R2 to span the overlapping region R1 and the non-overlapping region R2.

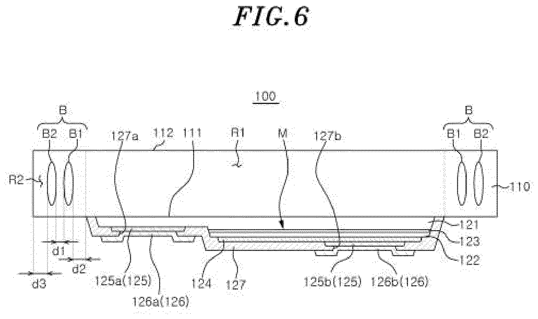

Meanwhile, in addition to this configuration, according to a third embodiment of the present disclosure, a plurality of light scattering regions B may be provided in the light transmitting layer 110. The light scattering region B of FIG. 6 is the same as the light scattering region B of FIG. 5 except for the number.

Referring to FIG. 6, the plurality of light scattering regions B may be formed symmetrically with respect to the center of the light emitting structure 120. In addition, the plurality of light scattering regions B may be disposed between the overlapping region R1 and the side end of the light transmitting layer 110 in the light irradiation region. The plurality of light scattering regions B includes a first light scattering region B1 and a second light scattering region B2.

A distance d1 between the first light scattering region B1 and the second light scattering region B2 may be formed to be less than or equal to a distance d2 between the first light scattering region B1 and the overlapping region R1. In addition, a distance d3 between the second light scattering region B2 and a side end of the light transmitting layer 110 may be formed to be less than or equal to the distance d1 between the first light scattering region B1 and the second light scattering region B2. By the light scattering region B disposed closer to the side end of the light transmitting layer 110, the light intensity decreasing toward the outside of the light transmitting layer 110 can be compensated. In this case, the uniformity of light emitted to the outside of the light transmitting layer 110 can be improved, and the light uniformity at various angles can be improved.

As such, since the void 113 may be formed in the light transmitting layer 110 of the display apparatus 1 according to the embodiments of the present disclosure, light emitted from the light emitting structure 120 may be refracted to increase the beam angle. In the present specification, the beam angle refers to a light emission angle showing a luminous intensity of 50% or more of the maximum luminous intensity in the light emitted from the light emitting device 100. For example, the beam angle refers to an angle between a first point at which the luminous intensity of light emitted from the light emitting device 100 is the highest and a second point at which the luminous intensity is 50% of that at the first point.

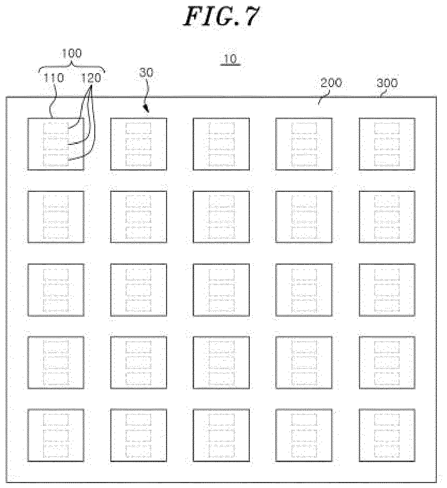

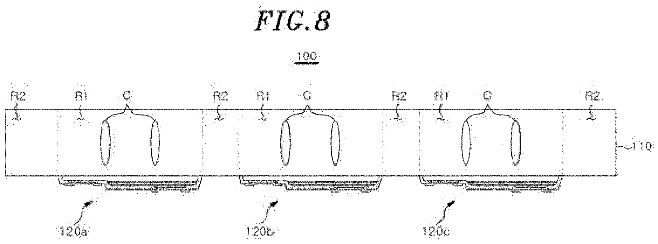

Meanwhile, in addition to such configurations, according to a fourth embodiment of the present disclosure, a plurality of light emitting structures 120 may be provided. Hereinafter, the fourth embodiment of the present disclosure will be described with further reference to FIGS. 7 and 8. In the description of the fourth embodiment, the differences compared to the above-described embodiment will be mainly described, and the same description and reference numerals as those in the above-described embodiments will be referred to.

Referring to FIGS. 7 and 8, a plurality of light emitting structures 120 may be provided. The plurality of light emitting structures 120 are disposed on the light transmitting layer 110, and the plurality of light emitting structures 120 may include a first light emitting structure 120a, a second light emitting structure 120b, and a third light emitting structure 120c.

The light transmitting layer 110 includes a plurality of light scattering regions C. The plurality of light scattering regions C may be the same as the light scattering regions A in FIG. 4 except for the arrangement region, shape, or pattern in the light transmitting layer 110.

For example, the plurality of light scattering regions C may be formed in the overlapping region R1 in the light irradiation region of the light transmitting layer 110. In other words, the light transmitting layer 110 has an overlapping region R1 corresponding to each of the plurality of light emitting structures 120, and at least one light scattering region C in the overlapping region R1 of the light transmitting layer 110 C may be provided. The plurality of light emitting structures 120 may include blue, green, and red light emitting structures 120. For example, the first light emitting structure 120a may emit red light, the second light emitting structure 120b may emit green light, and the third light emitting structure 120c may emit blue light.

The first light emitting structure 120a, the second light emitting structure 120b, and the third light emitting structure 120c may have different luminous intensities or beam angles of the emitted light depending on the implemented colors. For example, the first light emitting structure 120a may emit light having a lower luminous intensity than that of the third light emitting structure 120c. In addition, the third light emitting structure 120c may emit light having a luminous intensity same as or higher than that of the second light emitting structure 120b. Accordingly, the plurality of light scattering regions C formed in the light transmitting layer 110 may be more distributed in the region overlapping the first light emitting structure 120a. In this case, the luminous intensities of the plurality of light emitting structures 120 having different color gamuts can be uniformly adjusted.

In addition, the beam angle of the first light emitting structure 120a may be greater than or equal to that of the third light emitting structure 120c. The beam angle of the third light emitting structure 120c may be less than or equal to that of the second light emitting structure 120b. Accordingly, the plurality of light scattering regions C disposed in the light transmitting layer 110 may be more disposed in the overlapping region R1 of the first light emitting structure 120a or the overlapping region R1 of the second light emitting structure 120b. Accordingly, the beam angles of the plurality of light emitting devices having different color gamuts can be uniformly adjusted.

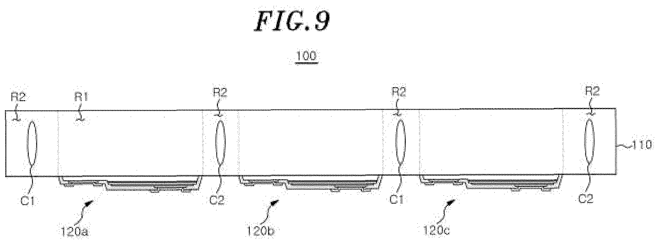

Meanwhile, in addition to such configurations, according to a fifth embodiment of the present disclosure, the light scattering region C may be formed in the non-overlapping region R2 in the light irradiation region of each of the plurality of light emitting structures 120. The light scattering region C of FIG. 9 is the same as the light scattering region C of FIG. 8 except for the arrangement.

Referring to FIG. 9, the plurality of light scattering regions C are disposed in the light transmitting layer 110 and disposed in the non-overlapping region R2 in the light irradiation region. The plurality of light scattering regions C includes a first light scattering region C1 and a second light scattering region C2. A distance between the first light scattering region C1 and the second light scattering region C2 may be greater than or equal to the width of the light emitting structure 120. In addition, a distance between the first light scattering region C1 and the second light scattering region C2 may be formed to be less than the thickness of the light transmitting layer 110. Since the first light scattering region C1 and the second light scattering region C2 are disposed in the non-overlapping region R2, the light intensities of the plurality of other light emitting structures 120 can be adjusted to be uniform by increasing the light scattering rate in the light irradiation region with relatively low light intensity. In this way, the arrangement of the plurality of light scattering regions may be adjusted according to the respective light characteristics of the plurality of light emitting structures 120.

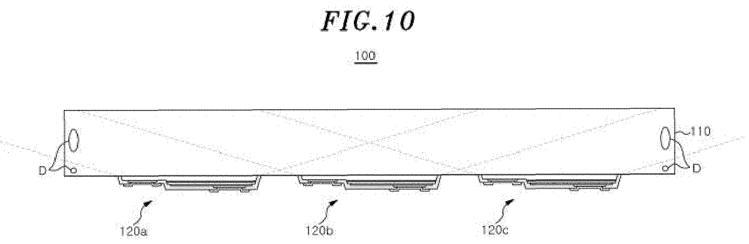

Meanwhile, in addition to such configurations, according to a sixth embodiment of the present disclosure, a light scattering region D may be formed in an region outside the beam angle of each of the plurality of light emitting structures 120. The light scattering region D of FIG. 10 is the same as the light scattering region C of FIG. 9 except for the arrangement.

Referring to FIG. 10, the light scattering region D is disposed in the light transmitting layer 110, and may be disposed within a region outside the beam angle of the plurality of light emitting structures 120. Since the region outside the beam angle of each of the plurality of light emitting structures 120 forms a light irradiation region with a relatively low luminous intensity, the uniformity of light may be deteriorated. In this case, by disposing the light scattering region D outside the beam angle of at least one light emitting structure 120 according to the characteristics of the beam angle and luminous intensity of each of the plurality of light emitting structures 120, the optical characteristics of the plurality of light emitting structures 120 having different color gamuts can be adjusted to be uniform. The light scattering region D may be formed closer to a side end of the light transmitting layer 110 than the overlapping region R1. Furthermore, the light scattering region D may be formed at the side end of the light transmitting layer 110.

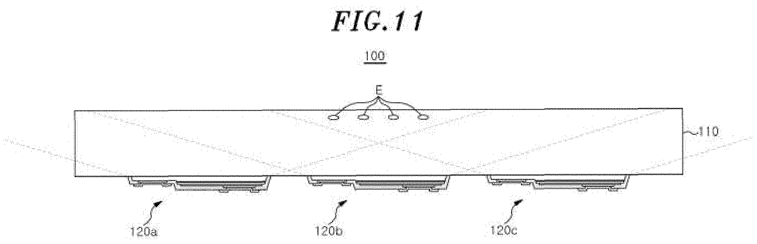

Meanwhile, in addition to such configurations, according to a seventh embodiment of the present disclosure, a light scattering region E may be formed in a region where the beam angles of the plurality of light emitting structures 120 overlap each other. The light scattering region E of FIG. 11 is the same as the light scattering region D of FIG. 10 except for the arrangement.

Referring to FIG. 11, the light scattering region E may be formed in the light transmitting layer 110, and may be formed in an overlapping region of an inner region of the light transmitting layer 110 where the light beam angles of the plurality of light emitting structures 120 overlap each other. For example, as the distance from the light emitting structures 120 increases, a region in which the beam angles between the plurality of light emitting structures 120 overlap occurs. In addition, since the luminous intensity decreases as the distance from the light emitting structure 120 increases, the luminous intensity in the region where the beam angles of the plurality of light emitting structures 120 overlap is lower than that in a central region, and the overall uniformity of light may be lowered. By disposing one or more light scattering regions E in the region where the beaming angles of the plurality of light emitting structures 120 overlap according to the characteristics of the beam angles and luminous intensities of the plurality of light emitting structures 120, the light characteristics of the plurality of light emitting structures having different color gamuts can be adjusted to be uniform.

In other words, by improving the beam angles of the plurality of light emitting structures 120 having different beam angles to be uniform, the deviation between the beam angles of the plurality of light emitting structures 120 can be reduced and the luminous intensity of each light emitting structure can be improved. In addition, since the deviation between the beam angles of the plurality of light emitting structures 120 may be reduced due to the voids 113, an uniform image of the display apparatus 1 can be formed even when viewed from various angles.

Meanwhile, in addition to such configurations, according to an eighth embodiment of the present disclosure, the light emitting device 100 may further include a second insulating layer 129. The light emitting device 100 according to the present embodiment may include the first insulating layer 127 and the second insulating layer 129. The light emitting device 100 of the present embodiment is the same as the light emitting device 100 of FIG. 3 except for the arrangement of the second insulating layer 129 and the bump layer 128.

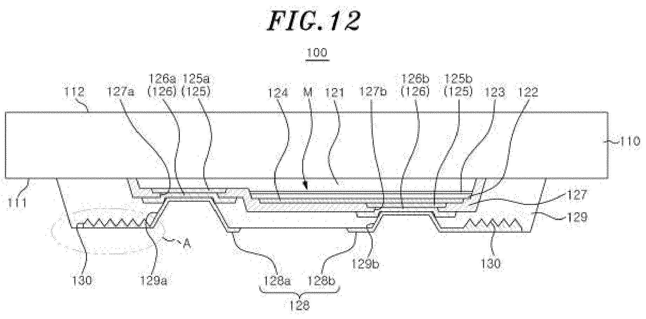

Referring to FIG. 12, the second insulating layer 129 may cover at least a portion of the first insulating layer 127, the first electrode pad 126a, and the second electrode pad 126b. The second insulating layer 129 may be formed to cover almost the entire surface except for a partial region of the first electrode pad 126a and a partial region of the second electrode pad 126b. The second insulating layer 129 may have a plurality of openings 129a and 129b through which the first electrode pad 126a and the second electrode pad 126b are exposed. That is, the second insulating layer 129 may include at least one third opening 129a through which a partial region of the first electrode pad 126a is exposed and at least one second opening 129a through which a partial region of the second electrode pad 126b is exposed. The third opening 129a and the fourth opening 129b of the second insulating layer 129 may have different widths. The third opening 129a and the fourth opening 129b of the second insulating layer 129 may be formed to have different thicknesses, and the third opening 129a may be formed to have a greater thickness than that of the fourth opening 129b. In addition, the third opening 129a and the fourth opening 129b may have different shapes.

The second insulating layer 129 may be formed to be thicker than the first insulating layer 127. In addition, the second insulating layer 129 may be formed to be thicker than the thickness of the light emitting structure 120, and may have a width greater than the width of the light emitting structure 120. The second insulating layer 129 is disposed to cover the side surface and the lower surface of the light emitting structure 120, and may serve to support the light emitting structure 120 as a whole.

The bump layer 128 includes a first bump electrode 128a and a second bump electrode 128b and is made of a conductive material. The bump layer 128 may reinforce the rigidity of the light emitting device 100. In other words, since the first bump electrode 128a and the second bump electrode 128b are provided on the second insulating layer 129, the stability of the overall structure of the light emitting device 100 can be increased. For example, the rigidity of the light emitting device 100 may be different between a region in which the second insulating layer 129 is provided and a region in which the second insulating layer 129 is not provided. By providing the bump layer 128 under the second insulating layer 129, the overall rigidity of the light emitting device 100 can be increased.

The first bump electrode 128a may contact the first electrode pad 126a through the third opening 129a to be electrically connected to the first conductivity type semiconductor layer 121. The second bump electrode 128b may contact the second electrode pad 126b through the fourth opening 129b to be electrically connected to the second conductivity type semiconductor layer 122. The first bump electrode 128a and the second bump electrode 128b may be disposed not only in a region overlapping the light emitting structure 120, but also in a region not overlapping the light emitting structure 120.

Referring to FIG. 12, the first bump electrode 128a and the second bump electrode 128b may be provided to extend outwardly from the region overlapping the light emitting structure 120. The first bump electrode 128a and the second bump electrode 128b may be provided as a conductor with easy heat dissipation, and thus the heat dissipation effect by the first bump electrode 128a and the second bump electrode 128b can be improved.

In the first bump electrode 128a, a step portion recessed toward the first electrode pad 126a from the lower surface of the second insulating layer 129 may be formed through the third opening 129a, and may be formed to be inclined along an inclined side surface of the third opening 129a. In addition, a lower region of the first bump electrode 128a is disposed on the lower surface of the second insulating layer 129, and an upper portion of the first bump electrode 128a is disposed in contact with one surface of the first electrode pad 126a. An extension region of the first bump electrode 128a connecting the upper region and the lower region of the first bump electrode 128a may be inclined along the inclined side surface of the third opening 129a.

In the second bump electrode 128b, a step portion recessed toward the second electrode pad 126b from the lower surface of the second insulating layer 129 may be formed through the fourth opening 129b, and may be formed to be inclined along the inclined side surface of the fourth opening 129b. In addition, a lower region of the second bump electrode 128b is disposed on the lower surface of the second insulating layer 129, and an upper portion of the second bump electrode 128b is disposed in contact with one surface of the second electrode pad 126b. An extension region of the second bump electrode 128b connecting the upper region and the lower region of the second bump electrode 128b may be inclined along the inclined side surface of the fourth opening 129b.

The extension region of the first bump electrode 128a and the extension region of the second bump electrode 128b may be formed at different angles from each other. In addition, the extension region of the first bump electrode 128a and the extension region of the second bump electrode 128b may have different lengths. The extension region of the first bump electrode 128a may be equal to or longer than the extension region of the second bump electrode 128b.

A shape corresponding to an uneven portion 130 to be described later may be formed on a surface of the second insulating layer 129 which is in contact with one surface of the bump layer 128. In other words, an uneven pattern may be formed on the surface of the second insulating layer 129. The uneven pattern of the second insulating layer 129 may be formed in various shapes by laser, grooving, etching, or the like. For example, when the bump layer 128 is laminated on the second insulating layer 129, the uneven portion 130 may be formed on one surface of the bump layer 128 due to the uneven pattern of the second insulating layer 129.

The bump layer 128 may be laminated on the second insulating layer 129. The bump layer 128 may be formed with the uneven portion 130 to increase the bonding force between the bump layer 128 and the second insulating layer 129. In addition, the uneven portion 130 may be formed on each of the first bump electrode 128a and the second bump electrode 128b. Due to the uneven portion 130, a contact area between the bump layer 128 and the second insulating layer 129 can be increased, and the bonding force between the second insulating layer 129 and the electrode layer 126 can be increased.

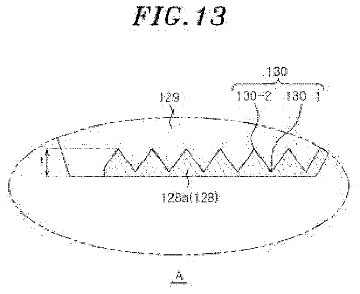

Referring to FIG. 13, the uneven portion 130 may be formed on one surface of both surfaces of the bump layer 128 which faces the second insulating layer 129. For example, the uneven portion 130 may be formed in a region of the bump layer 128 that does not overlap the light emitting structure 120. In addition, the uneven portion 130 may include a plurality of concave portions 130-1 and a plurality of convex portions 130-2. The plurality of concave portions 130-1 and the plurality of convex portions 130-2 may be alternately disposed along the surface of the second insulating layer 129. Further, the convex portion 130-2 of the uneven portion 130 may be formed to protrude toward the second insulating layer 129, and the concave portion 130-1 may be formed to be spaced apart from the second insulating layer 129. The convex portion 130-2 and the concave portion 130-1 may be formed in various shapes. For example, the convex portion 130-2 and the concave portion 130-1 may have a triangular cross section. As another example, the convex portion 130-2 and the concave portion 130-1 may have a curved cross section. As still another example, the convex portion 130-2 and the concave portion 130-1 may have a polygonal cross-section. Furthermore, a length from the end of the concave portion 130-1 of the uneven portion 130 to the end of the convex portion 130-2 in the laminating direction may be formed to be at least half the thickness of the bump layer 128 in the laminating direction. Moreover, a length 1 from the end of the convex portion 130-2 to the other surface of the bump layer 128 may be formed to be 1 µm or more and 3 µm or less.

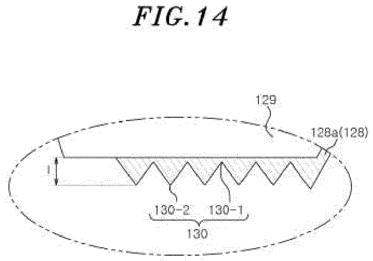

Meanwhile, although it has been described above that the uneven portion 130 is formed on one surface of both surfaces of the bump layer 128 which faces the second insulating layer 129, this is only an example and the present disclosure is not limited thereto. Accordingly, according to a modified example of the eighth embodiment of the present disclosure, the uneven portion 130 may be formed only on a surface opposite to one surface of the bump layer 128 facing the second insulating layer 129. In this case, the uneven portion 130 may be formed to face the outside of the light emitting structure 120 (see FIG. 14).

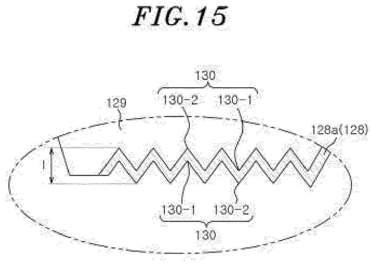

In addition, according to another modification of the eighth embodiment of the present disclosure, the uneven portion 130 may be formed on both surfaces of the bump layer 128. In this case, the convex portions 130-2 of the uneven portion 130 formed on the other surface of both surfaces of the bump layer 128 which is opposite to the one surface in contact with the second insulating layer 129 may protrude in a direction away from the second insulating layer 129, and the concave portion 130-1 may be concave toward the second insulating layer 129. Further, a length 1 from the end of the convex portion 130-2 of the uneven portion 130 formed on one surface of the bump layer 128 to the end of the convex portion 130-2 of the uneven portion 130 formed on the other surface may be formed to be 1 µm or more and 3 µm or less. (See Fig. 15).

According to one embodiment of the present disclosure, since the uneven portion 130 may be formed on one surface of the bump layer 128 of the light emitting device 100, the bonding strength of the light emitting device 100 can be increased. In other words, the contact area between the second insulating layer 129 and the bump layer 128 is increased by the uneven portion 130 on one surface of the bump layer 128, so that the bonding force between the second insulating layer 129 and the bump layer 128 can be increased, which improves the reliability of the light emitting device 100.

Meanwhile, in addition to such configurations, according to a ninth embodiment of the present disclosure, the light emitting structure 120 may further include an insulating film 131.

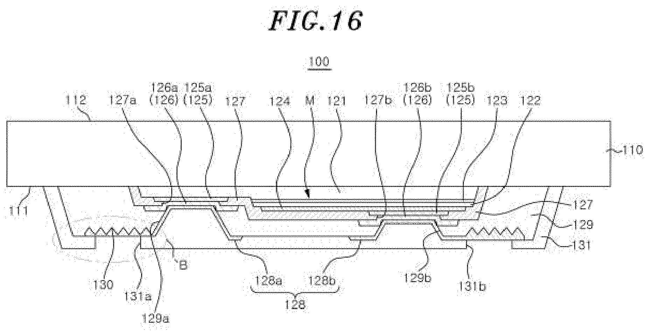

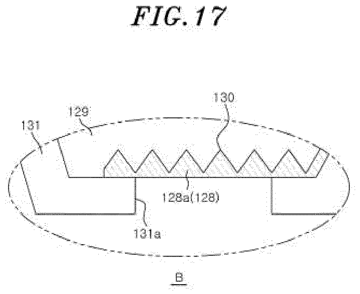

Referring to FIGS. 16 and 17, the insulating film 131 may cover at least a portion of the bump layer 128 and the second insulating layer 129. In addition, a plurality of openings 131a and 131b may be formed in the insulating film 131 to expose the bump layer 128. The insulating film 131 includes a fifth opening 131a through which a portion of the lower surface of the first bump electrode 128a is exposed and a sixth opening 131b through which a portion of the lower surface of the second bump electrode 128b is exposed. The first bump electrode 128a and the second bump electrode 128b may be electrically connected to another device through the fifth opening 131a and the sixth opening 131b, and may receive power from the outside. Further, a surface of the insulating film 131 that does not contact the uneven portion 130 of the bump layer 128 may be formed to be flat.

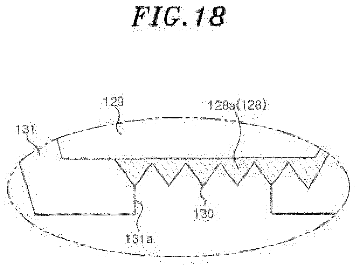

Meanwhile, although it has been described above that the uneven portion 130 is formed on one surface of both surfaces of the bump layer 128 which faces the second insulating layer 129, this is only an example and the present disclosure is not limited thereto. Accordingly, according to a modified example of the ninth embodiment of the present disclosure, the uneven portion 130 may be formed only on a surface opposite to one surface of the bump layer 128 facing the second insulating layer 129. In this case, the uneven portion 130 may be formed to face the outside of the light emitting structure 120. In addition, a portion of the insulating film 131 in contact with the uneven portion 130 of the bump layer 128 may have an uneven pattern corresponding to the shape of the uneven portion 130 (see FIG. 18 ).

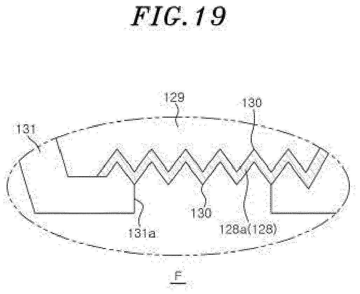

Moreover, according to another modified example of the ninth embodiment of the present disclosure, the uneven portion 130 may be formed on both surfaces of the bump layer 128. In this case, the convex portion 130-2 of the uneven portion 130 formed on the other surface of the bump layer 128 that is the opposite surface to the one surface contacting the second insulating layer 129 may protrude in a direction away from the second insulating layer 129, and the concave portion 130-1 may be formed to be concave toward the second insulating layer 129 (see FIG. 19).

Meanwhile, in addition to such configurations, according to a tenth embodiment of the present disclosure, the light emitting structure 120 may further include an adhesive layer 132 and a black blocking layer 133.

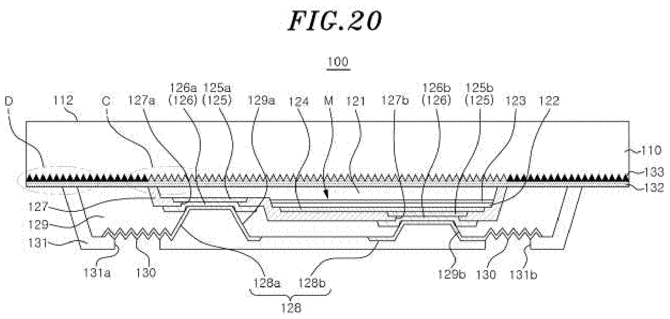

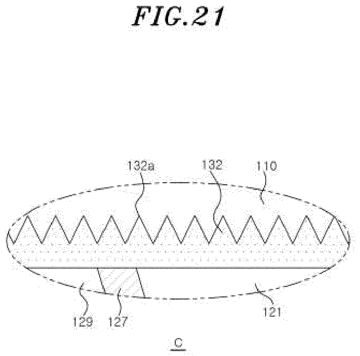

Referring to FIGS. 20 and 21, the adhesive layer 132 may be disposed between the light transmitting layer 110 and the light emitting structure 120. The adhesive layer 132 may adhere the light emitting structure 120 to the light transmitting layer 110. In addition, an uneven portion 132a may be formed on the adhesive layer 132 by the light transmitting layer 110. In other words, the uneven portion 132a may be formed on a surface of the light transmitting layer 110 in contact with the adhesive layer 132. The contact area between the adhesive layer 132 and the light transmitting layer 110 is increased due to the uneven portion 132a, so that the bonding force between the adhesive layer 132 and the light-transmitting layer 110 can be increased.

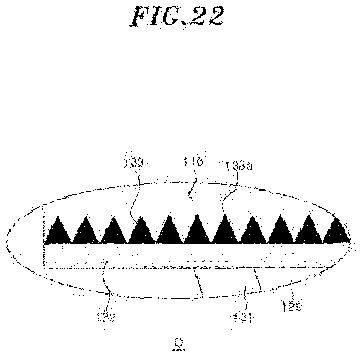

Referring to FIG. 22, the black blocking layer 133 may be disposed between the light transmitting layer 110 and the adhesive layer 132. The black blocking layer 133 may serve to block or absorb light. In other words, the black blocking layer 133 may prevent light emitted from the light emitting structure 120 from being emitted to the side of the light transmitting layer 110 without being emitted in the laminating direction. In addition, an uneven portion 133a may be formed on the black blocking layer 133. In other words, the uneven portion133a may be formed on a surface of the light transmitting layer 110 in contact with the black blocking layer 133. The contact area between the black blocking layer 133 and the light transmitting layer 110 is increased by the uneven portion 133a, so that the bonding force between the black blocking layer 133 and the light transmitting layer 110 can be increased.

In the present embodiment, the uneven portion 130 formed on the bump layer 128 may be referred to as a first uneven portion 130, and the uneven portion 132a formed on the adhesive layer 132 may be referred to as a second uneven portion 132a, the uneven portion 133a formed on the black blocking layer 133 may be referred to as a third uneven portion 133a.

As described above, the light emitting structure 120 can be efficiently bonded to the light transmitting layer 110 by the adhesive layer 132. In addition, the contact area of the adhesive layer 132 with the light transmitting layer 110 can be increased due to the uneven portion formed on the light transmitting layer 110. In other words, the bonding force between the adhesive layer 132 and the light transmitting layer 110 can be increased.

Light emitted from the light emitting structure 120 may be emitted in the laminating direction by the black blocking layer 133. In addition, an area of the black blocking layer 133 in contact with the light transmitting layer 110 can be increased due to the uneven portion formed on the light transmitting layer 110. In other words, the bonding force between the black blocking layer 133 and the light transmitting layer 110 can be increased.

Although the embodiments of the present disclosure have been described as specific embodiments, these are merely examples. The present disclosure is not limited thereto and should be construed as having the widest scope according to the technical idea disclosed in the present specification. Those skilled in the art may implement a pattern of a shape not specified above by combining/substituting the disclosed embodiments, without departing from the scope of the present disclosure. In addition, those skilled in the art may easily change or modify the embodiments disclosed based on the present specification, and it is clear that such changes or modifications also fall within the scope of the present disclosure.

## Claims

1. A light emitting module comprising:
a light emitting structure configured to emit light; and
a light transmitting layer configured to transmit light emitted from the light emitting structure,
wherein the light transmitting layer has a light scattering region in which one or more voids for refracting the light are formed.

2. The light emitting module of claim 1, wherein the light scattering region is formed in a region of the light transmitting layer which overlaps the light emitting structure.

3. The light emitting module of claim 1, wherein the light scattering region is formed in a non-overlapping region of the light transmitting layer which does not overlap the light emitting structure.

4. The light emitting module of claim 3, wherein the light scattering region includes a plurality of light scattering regions, and a distance between the plurality of light scattering regions is less than or equal to a distance between any one of the plurality of light scattering regions and the overlapping region.

5. The light emitting module of claim 1, wherein the one or more voids include a plurality of voids, and the plurality of voids are spaced apart from each other in the light scattering region.

6. The light emitting module of claim 1, wherein the light transmitting layer has a light incident surface facing the light emitting structure, and the one or more voids are disposed between a point of 30% of a thickness of the light transmitting layer from the light incident surface and a point of 60% of the thickness of the light transmitting layer from the light incident surface.

7. The light emitting module of claim 1, wherein each of the one or more voids has a predetermined major axis length in a longitudinal direction with a longest length between opposite ends and a predetermined minor axis length in a transverse direction with a shortest length between opposite ends, and the major axis length is 7 µm or more and 35 µm or less.

8. The light emitting module of claim 7, wherein the minor axis length is 2 µm or more and 6 µm or less.

9. The light emitting module of claim 1, wherein the light emitting structure includes a plurality of light emitting structures, and the plurality of light emitting structures are supported on the light transmitting layer so as to be spaced apart from each other, and
wherein the one or more voids refract light emitted from each of the plurality of light emitting structures.

10. The light emitting module of claim 9, wherein the plurality of light emitting structures have different beam angles.

11. The light emitting module of claim 10, wherein the light scattering region is formed in a region where two or more beam angles of the plurality of light emitting structures overlap in an inner region of the light transmitting layer.

12. The light emitting module of claim 10, wherein the light scattering region is formed in a region where the beam angles of the plurality of light emitting structures do not overlap in an inner region of the light transmitting layer.

13. The light emitting module of claim 9, wherein the one or more voids include a plurality of voids, and the plurality of voids are arranged to be spaced apart from each other in a thickness direction of the light transmitting layer, or arranged to be spaced apart from each other along a direction in which the plurality of light emitting structures are arranged.

14. The light emitting module of claim 1, wherein the light emitting structure includes:
a first conductivity type semiconductor layer; and
a mesa laminated on a partial region of the first conductivity type semiconductor layer and including an active layer and a second conductivity type semiconductor layer, and
wherein each of the one or more voids has a major axis length in a longitudinal direction with a longest length between opposite ends and a minor axis length in a transverse direction with a shortest length between opposite ends, and the major axis length is smaller than a thickness of the first conductivity type semiconductor layer.

15. The light emitting module of claim 14, wherein the minor axis length is smaller than a thickness of the active layer.

16. The light emitting module of claim 14, wherein the light emitting structure includes:
an electrode layer electrically connected to the first conductivity type semiconductor layer and the mesa;
an insulating layer covering the first conductivity type semiconductor layer and the mesa; and
a bump layer covering the insulating layer and having an uneven portion formed on one surface facing the insulating layer.

17. The light emitting module of claim 16, wherein the uneven portion includes a plurality of convex portions and a plurality of concave portions, and a length from an end of the convex portions of the uneven portion of the bump layer to an opposite surface to the one surface of the bump layer is 1 µm or more and 3 µm or less.

18. The light emitting module of claim 17, wherein a shape corresponding to the uneven portion is formed on a surface of the insulating layer which is in contact with the uneven portion of the bump layer.

19. A light emitting module comprising:
a light emitting structure configured to emit light; and
a light transmitting layer configured to transmit light emitted from the light emitting structure,
wherein the light emitting structure includes:
a first conductivity type semiconductor layer;
a mesa laminated on a partial region of the first conductivity type semiconductor layer and including an active layer and a second conductivity type semiconductor layer;
an adhesive layer for bonding the first conductivity type semiconductor layer to the light transmitting layer; and
a black blocking layer disposed between the light transmitting layer and the adhesive layer and configured to partially block light emitted from the light emitting structure.

20. A display apparatus comprising:
a plurality of light emitting modules; and
a panel substrate supporting the plurality of light emitting modules,
wherein the light emitting module includes:
a light emitting structure configured to emit light; and
a light transmitting layer configured to transmit light emitted from the light emitting structure, and
wherein the light transmitting layer has a light scattering region in which one or more voids for refracting the light are formed.
